Europäisches Patentamt

European Patent Office

Office européen des brevets

(11) Publication number: **0 090 572**
**B1**

(12) **EUROPEAN PATENT SPECIFICATION**

(45) Date of publication of patent specification: **25.10.89**

(21) Application number: **83301573.8**

(22) Date of filing: **21.03.83**

(51) Int. Cl.⁴: **G 11 C 11/40, G 11 C 7/00**

(54) **Semiconductor sense-amplifier circuitry.**

(30) Priority: **30.03.82 JP 50089/82**

(43) Date of publication of application:
**05.10.83 Bulletin 83/40**

(45) Publication of the grant of the patent:
**25.10.89 Bulletin 89/43**

(84) Designated Contracting States:
**DE FR GB**

(56) References cited:
**US-A-3 909 631**
**US-A-4 136 292**

**PATENTS ABSTRACTS OF JAPAN, vol.3, no. 26
(E-95), 6th March 1979; & JP - A - 544 029
(NIPPON DENKI K.K.) 12-01-1979**

**IBM TECHNICAL DISCLOSURE BULLETIN, vol.
14, no. 10, March 1972, pages 2885,2886; H.
LEUNG et al.: "Array on-chip sense amplifier"**

(73) Proprietor: **FUJITSU LIMITED
1015, Kamikodanaka Nakahara-ku
Kawasaki-shi Kanagawa 211 (JP)**

(72) Inventor: **Kurafuji, Setsuo
993-2, Shiboguchi Takatsu-ku
Kawasaki-shi Kanagawa 213 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

**Description**

The present invention relates to semiconductor sense amplifier circuitry, for example, for use in a memory circuit. More particularly, it relates to a differential amplifier for amplifying the difference in potential between a data signal and a reference voltage.

Generally, in a metal-oxide semiconductor (MOS) static memory circuit, a sense amplifier and an output buffer are provided at the output portion thereof (cf. e.g. US—A—4 136 292). The sense amplifier is usually comprised of one or more stages of differential amplifiers, including a differential amplifier for amplifying the difference in potential between a data signal and a reference voltage.

The conductance $g_m$ of an MOS transistor decreases as the temperature increases. Therefore, a high level, i.e. an on-output level, of the output buffer, obtained by the supply of an output of the differential amplifier, has a negative temperature coefficient. A change in the on-output level of the output buffer can create serious problems in a circuit such as an emitter-coupled logic (ECL) circuit.

IBM Technical Disclosure Bulletin, Vol. 14, No. 10, March 1972, pages 2885—2886, discloses an array on-chip sense amplifier whose output current is determined by a current source provided with temperature compensation by an arrangement transistors, a diode and a resistor.

According to one aspect of the present invention, there is provided a semiconductor device including reference-potential supply circuitry, for delivering a reference voltage when energised from first and second power supply means and a differential amplifier having a first input for receiving a data signal and having a second input connected to receive the reference voltage for amplifying a difference in potential between the data signal and the reference voltage when the amplifier is energised from said first and second power supply means, characterised in that the reference-potential supply circuitry comprises a temperature-compensating circuit connected to said first and second power supply means and operable to generate said reference voltage with a temperature characteristic which compensates for a variation of an output signal of the device that would otherwise occur with changes of ambient temperature, said temperature-compensating circuit including:

a first resistor connected to said first power supply means;

an enhancement-type transistor having a drain connected to said first resistor, said drain delivering said reference voltage, a gate, and a source connected to said second power supply means; and

second and third resistors, connected between said first and second power supply means, for applying a constant voltage at their inter-connection point to the gate of said enhancement-type transistor.

According to a second aspect of the present invention, there is provided a semiconductor device including reference-potential supply circuitry, for delivering a reference voltage when energised from first and second power supply means, and a differential amplifier having a first input for receiving a data signal, and having a second input connected to receive said reference voltage, for amplifying a difference in potential between said data signal and said reference voltage when the amplifier is energised from said first and second power supply means, characterised in that the reference-potential supply circuitry comprises a temperature-compensating circuit connected to said first and second power supply means and operable to generate said reference voltage with a temperature characteristic which compensates for a variation of an output signal of the device that would otherwise occur with changes of ambient temperature, said temperature-compensating circuit including:

a resistor connected to said first power supply means; and

a depletion-type transistor having a drain connected to said resistor, said drain delivering said reference voltage, and a gate connected to the source thereof, which source is connected to said second power supply means.

An embodiment of the present invention can provide a semiconductor device having a sense amplifier in which a reference voltage is changed in dependence upon a change in the temperature of the device, so as to stabilize the on-output level of an output buffer.

Reference will now be made, by way of example, to the accompanying drawings, wherein:

Figure 1 is a graph of margins of an ECL level;

Fig. 2 is a circuit diagram illustrating an embodiment of a semiconductor device according to the present invention;

Fig. 3 is a circuit diagram illustrating part of another embodiment of the present invention;

Fig. 4 is a graph illustrating the characteristics of the reference voltage $V_{REF}$ of Fig. 2 and Fig. 3; and

Fig. 5 is a graph illustrating the characteristics of the on-output $V_{OH}$ of Fig. 2.

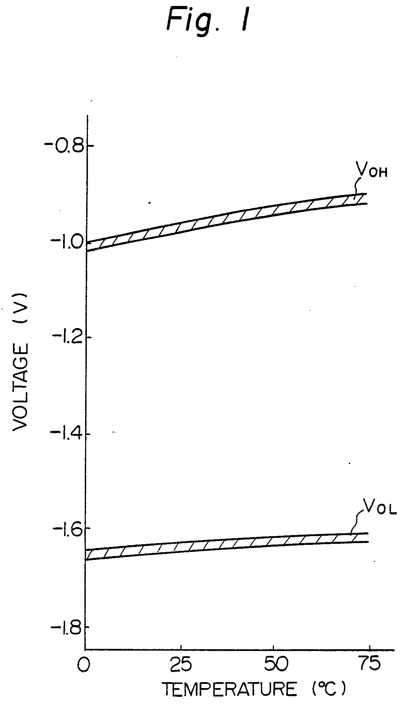

As is illustrated in Fig. 1, in an ECL circuit, two levels, i.e., a high level $V_{OH}$ and a low level $V_{OL}$, are used. The low level $V_{OL}$ increases slightly as the temperature increases. On the other hand, the high level $V_{OH}$ increases more rapidly as the temperature increases. A semiconductor device embodying the present invention can be used for generating signals for an ECL circuit having bilevel signals, as is shown in Fig. 1.

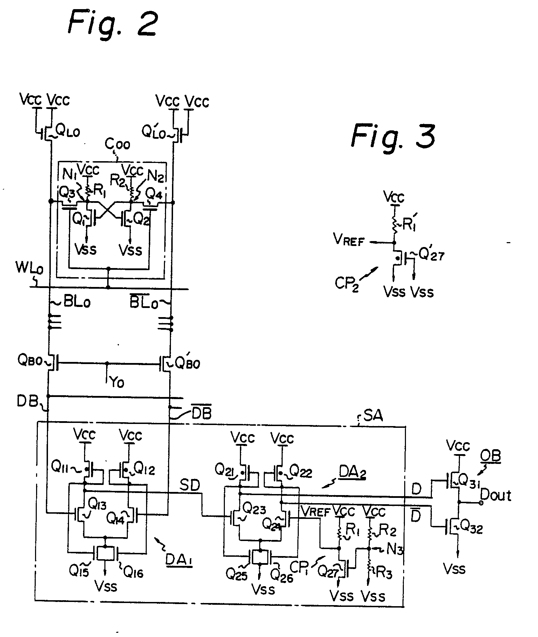

In Fig. 2, which illustrates an embodiment of the present invention, $C_{00}$ designates a memory cell, $WL_0$ designates a word line $BL_0$ and $\overline{BL_0}$ designate bit lines, $Q_{L0}$ and $Q'_{L0}$ designate load transistors, $Q_{B0}$ and $Q'_{B0}$ designate column selection transistors selected by a column selection signal $Y_0$, DB and $\overline{DB}$ designate data bit lines, SA designates a sense amplifier, and OB designates an output buffer.

$V_{cc}$ designates a first power supply and its

potential and $V_{ss}$ designates a second power supply and its potential. In the case of an ECL level, $V_{cc}$ is the ground level and $V_{ss}$ is $-5.2$ volts while in the case of a transistor-transistor logic level, $V_{cc}$ is $+5$ volts and $V_{ss}$ is the ground level.

The memory cell $C_{00}$ is comprised of resistors $R_1$ and $R_2$, cross-coupled driver transistors $Q_1$ and $Q_2$, and transfer transistors $Q_3$ and $Q_4$.

The sense amplifier SA is comprised of a first differential amplifier $DA_1$, a second differential amplifier $DA_2$, and a temperature-compensating circuit $CP_1$. The first differential amplifier $DA_1$ is comprised of depletion-type load transistors $Q_{11}$ and $Q_{12}$ connected to the power supply $V_{cc}$, enhancement-type input transistors $Q_{13}$ and $Q_{14}$ for receiving data signals of the data bit lines DB and $\overline{DB}$, and enhancement-type load transistors $Q_{15}$ and $Q_{16}$ connected between the input transistors $Q_{13}$ and $Q_{14}$ and the power supply $V_{ss}$. The second differential amplifier $DA_2$ has the same configuration as the first differential amplifier $DA_1$. That is, the elements $Q_{21}$ through $Q_{26}$ of the second differential amplifier $DA_2$ correspond to the elements $Q_{11}$ through $Q_{16}$ of the first differential amplifier $DA_1$. The first differential amplifier $DA_1$ detects and amplifies the difference in potential between the data bit lines DB and $\overline{DB}$ while the second differential amplifier $DA_2$ detects and amplifies the difference in potential between an output SD of the first differential amplifier $DA_1$ and a reference voltage $V_{REF}$ so as to transmit its outputs D and $\overline{D}$ to the output buffer OB.

The reference voltage $V_{REF}$ is changed by the temperature-compensating circuit $CP_1$, which comprises resistors $R_1$, $R_2$, and $R_3$ and an enhancement-type transistor $Q_{27}$.

The circuit of Fig. 2 is operated by making the potential at the word line $WL_0$ high so as to turn on the transfer transistors $Q_3$ and $Q_4$ and by simultaneously or subsequently making the column selection signal $Y_0$ high so as to turn on the transistors $Q_{B0}$ and $Q'_{B0}$. In this state, if the transistors $Q_1$ and $Q_2$ are in an on state and in an off state, respectively, the potential at the node $N_1$ is low and the potential at the node $N_2$ is high, and, accordingly, the potential at the bit line $BL_0$ is low and the potential at the bit line $\overline{BL_0}$ is high. In addition, the potential at the data bit line DB is low and the potential at the data bit line $\overline{DB}$ is high. The difference in potential between the data bit lines DB and $\overline{DB}$ is detected and amplified by the first differential amplifier $DA_1$.

Next, the difference in potential between the output SD of the first differential amplifier $DA_1$ and the reference voltage $V_{REF}$ is detected and amplified by the second differential amplifier $DA_2$, whose outputs D and $\overline{D}$ are transmitted to the gates of the transistors $Q_{31}$ and $Q_{32}$ of the output buffer OB, respectively. Therefore, if the potential of the output D is low and the potential of the output $\overline{D}$ is high, the potential of the output $D_{OUT}$ is low. This low potential is referred to as $V_{OL}$. Contrary to this, if the potential of the output D is high and the potential of the output $\overline{D}$ is low, the potential of the output $D_{OUT}$ is high. This high potential is referred to as $V_{OH}$. In this case, the low potential $V_{OL}$ and the high potential $V_{OH}$ of the output $D_{OUT}$ are determined by the ratio of the conductance $g_m$ of the transistor $Q_{31}$ to that of the transistor $Q_{32}$.

Therefore, even if the high potential of the output D and the low potential of the output $\overline{D}$ are definite, when the temperature increases, the high potential $V_{OH}$ of the output $D_{OUT}$ decreases. This is because the conductance $g_m$ of each of the transistors $Q_{31}$ and $Q_{32}$ decreases as the temperature increases. Thus, the reduced high potential $V_{OH}$ creates a disadvantage in an ECL circuit which has the characteristics shown in Fig. 1.

In an embodiment of the present invention, the above-mentioned disadvantage can be reduced since the reference voltage $V_{REF}$ is increased by the temperature-compensating circuit $CP_1$ as the temperature increases.

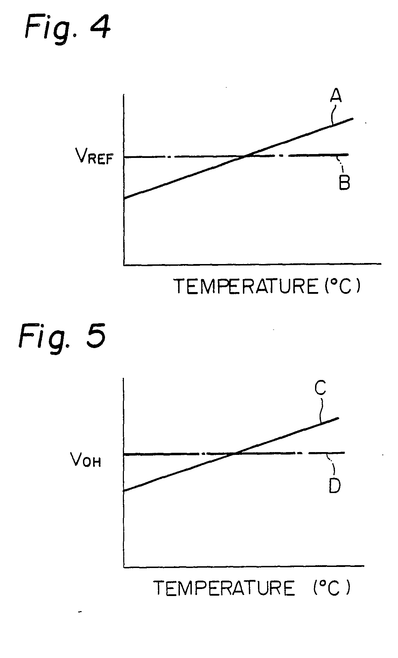

The temperature-compensating circuit $CP_1$ will now be explained in more detail. Since the potential at the node $N_3$ between the resistors $R_2$ and $R_3$ is almost constant regardless of the temperature, the gate potential of the transistor $Q_{27}$ is almost constant. In the transistor $Q_{27}$, when the temperature increases, the conductance $g_m$ of the transistor $Q_{27}$ decreases so as to increase the saturated voltage between the drain and source of the transistor $Q_{27}$, i.e., the reference voltage $V_{REF}$ indicated by the line A in Fig. 4. The line B in Fig. 4 indicates the reference voltage $V_{REF}$ of the prior art.

Therefore, in the second differential amplifier $DA_2$, the difference in potential between the output SD and the reference voltage $V_{REF}$ increases as the temperature increases. As a result, the high potential of the output D becomes high and the low potential of the output $\overline{D}$ becomes low. Therefore, in the output buffer OB, the transistor $Q_{31}$ is thoroughly controlled in the on direction while the transistor $Q_{32}$ is thoroughly controlled in the off direction.

Thus, the decrease in the conductance $g_m$ of the transistor $Q_{31}$ due to the increase in temperature is compensated for by the increase in the gate potential applied to the transistor $Q_{31}$. Accordingly, the high potential $V_{OH}$ of the output $D_{OUT}$ never decreases and has a positive temperature coefficient, as is shown by the line C in Fig. 5. The line D in Fig. 5 shows the temperature coefficient of the prior art.

In Fig. 3, which illustrates part of another embodiment of the invention, a temperature-compensating circuit $CP_2$ comprised of a resistor $R'_1$ and a depletion-type transistor $Q'_{27}$ is used as the temperature-compensating circuit $CP_1$ of Fig. 2. This depletion-type transistor $Q'_{27}$ is manufactured by the same process as the transistors $Q_{11}$, $Q_{12}$, $Q_{21}$, and $Q_{22}$.

A change in the reference voltage $V_{REF}$ of the temperature-compensating circuit $CP_2$ due to a change in the temperature is the same as that of the temperature-compensating circuit $CP_1$. In addition to temperature compensation, the embodiment of Fig. 3 has an advantage in that fluctuation of the conductance $g_m$ of each of the depletion-type transistors $Q_{21}$ and $Q_{22}$ is compensated for. That is, if the conductance $g_m$ of each of the transistors $Q_{21}$ and $Q_{22}$ decreases due to fluctuation of the manufacturing process, the high potential of the output D decreases. As a result, the high potential $V_{OH}$ of the output $D_{OUT}$ decreases and the low potential $V_{OL}$ of the output $D_{OUT}$ increases. However, in this embodiment, the conductance $g_m$ of the transistor $Q'_{27}$ also decreases so as to increase the reference voltage $V_{REF}$. As a result, the high potential of the output D becomes high and the low potential of the output $\overline{D}$ becomes low. Thus, fluctuation of the conductance $g_m$ of the transistors $Q_{21}$ and $Q_{22}$ due to the manufacturing process is compensated for.

Not that the characteristics of a depletion-type transistor are greatly dependent upon the process of ion-implanting impurities in a channel area of an enhancement-type transistor to change the transistor from an enhancement-type transistor to a depletion-type transistor. As was explained above, in the embodiment of Fig. 3, the depletion-type transistor $Q'_{27}$, which is manufactured by the same process as the transistors $Q_{21}$ and $Q_{22}$, enables the fluctuation of the manufacturing process to be compensated for.

As was explained hereinbefore, in an embodiment of the present invention, the reference voltage $V_{REF}$ of the differential amplifier $DA_2$ increases as the temperature increases. As a result, the difference between the high potential of the output D and the low potential of the output $\overline{D}$ of the differential amplifier $DA_2$ can be increased, and, accordingly, when the outputs D and $\overline{D}$ are used in the output buffer OB, the high potential $V_{OH}$ of the output $D_{OUT}$ is never decreased.

## Claims

1. A semiconductor device including reference-potential supply circuitry, for delivering a reference voltage $(V_{REF})$ when energised from first and second power supply means $(V_{CC}, V_{SS})$, and a differential amplifier $(DA_2)$ having a first input for receiving a data signal (SD), and having a second input connected to receive said reference voltage $(V_{REF})$, for amplifying a difference in potential between said data signal (SD) and said reference voltage $(V_{REF})$ when the amplifier is energised from said first and second power supply means $(V_{CC}, V_{SS})$, characterised in that the reference-potential supply circuitry comprises a temperature-compensating circuit $(CP_1)$ connected to said first and second power supply means $(V_{CC}, V_{SS})$ and operable to generate said reference voltage $(V_{REF})$ with a temperature characteristic which compensates for a variation of an output signal $(D_{OUT})$ of the device that would otherwise occur with changes of ambient temperature, said temperature-compensating circuit $(CP_1)$ including:

a first resistor $(R_1)$ connected to said first power supply means $(V_{CC})$;

an enhancement-type transistor $(Q_{27})$ having a drain connected to said first resistor $(R_1)$, said drain delivering said reference voltage $(V_{REF})$, a gate, and a source connected to said second power supply means $(V_{SS})$; and

second and third resistors $(R_2, R_3)$, connected between said first and second power supply means $(V_{CC}, V_{SS})$, for applying a constant voltage at their interconnection point $(N_3)$ to the gate of said enhancement-type transistor $(Q_{27})$.

2. A semiconductor device including reference-potential supply circuitry, for delivering a reference voltage $(V_{REF})$ when energised from first and second power supply means $(V_{CC}, V_{SS})$, and a differential amplifier $(DA_2)$ having a first input for receiving a data signal (SD), and having a second input connected to receive said reference voltage $(V_{REF})$, for amplifying a difference in potential between said data signal (SD) and said reference voltage $(V_{REF})$ when the amplifier is energised from said first and second power supply means $(V_{CC}, V_{SS})$, characterised in that the reference-potential supply circuitry comprises a temperature-compensating circuit $(CP_2)$ connected to said first and second power supply means $(V_{CC}, V_{SS})$ and operable to generate said reference voltage $(V_{REF})$ with a temperature characteristic which compensates for a variation of an output signal $(D_{OUT})$ of the device that would otherwise occur with changes of ambient temperature, said temperature-compensating circuit $(CP_2)$ including:

a resistor $(R'_1)$ connected to said first power supply means $(V_{CC})$; and

a depletion-type transistor $(Q'_{27})$ having a drain connected to said resistor $(R'_1)$, said drain delivering said reference voltage $(V_{REF})$, and a gate connected to the source thereof, which source is connected to said second power supply means $(V_{SS})$.

3. A semiconductor device as claimed in claim 1 or 2, wherein said differential amplifier $(DA_2)$ comprises:

first and second load means $(Q_{21}, Q_{22})$ connected to said first power supply means $(V_{CC})$;

a first enhancement-type MIS transistor $(Q_{23})$ having a drain connected to said first load means $(Q_{21})$, a gate for receiving said data signal (SD), and a source;

a second enhancement-type MIS transistor $(Q_{24})$ having a drain connected to said second load means $(Q_{22})$, a gate for receiving said reference voltage $(V_{REF})$, and a source; and

a third load means $(Q_{25}, Q_{26})$ connected between said second power supply means $(V_{SS})$ and the sources of the first and second transistors $(Q_{23}, Q_{24})$.

4. A semiconductor device as claimed in Claim 3, wherein each of said first and second load means $(Q_{21}, Q_{22})$ comprises depletion-type transistors having a drain connected to said first power supply means $(V_{CC})$ and a gate connected to the source thereof.

5. A semiconductor device as claimed in claim 3 or 4, wherein said third load means $(Q_{25}, Q_{26})$

comprises third and fourth enhancement-type transistors connected in parallel, each having a drain connected to the source of said first enhancement-type transistor ($Q_{23}$) and to the source of said second enhancement-type transistor ($Q_{24}$), a gate connected to one of said first and second load means ($Q_{21}$, $Q_{22}$) and a source connected to said second power supply means ($V_{SS}$).

6. A semiconductor device as claimed in any preceding claim, further comprising an output buffer (OB) having two input terminals, each connected to a respective one of said first and second load means ($Q_{21}$, $Q_{22}$) to receive respective output signals (D, $\overline{D}$) of the differential amplifier ($DA_2$) and having an output terminal for generating an output signal ($D_{out}$) of the device.

7. A semiconductor device as claimed in claim 6, wherein said output buffer (OB) comprises:

a third enhancement-type transistor ($Q_{31}$) having a drain connected to said first power supply means ($V_{CC}$), a gate connected to said first load means ($Q_{21}$), and a source for generating said output signal ($D_{out}$) of the device; and

a fourth enhancement-type transistor ($Q_{32}$) having a drain connected to the source of said third enhancement-type transistor ($Q_{31}$), a gate connected to said second load means ($Q_{22}$), and a source connected to said second power supply means ($V_{SS}$).

8. A semiconductor device as claimed in any preceding claim, wherein the temperature characteristic of said reference voltage ($V_{REF}$) is such as to impart to said output signal ($D_{out}$) of the device a non-negative temperature characteristic.

9. A semiconductor device as claimed in claim 8, wherein said non-negative temperature characteristic is a positive temperature characteristic similar to that of a high potential level ($V_{OH}$) of an external ECL circuit.

**Patentansprüche**

1. Halbleitervorrichtung mit einer Referenzpotential-Versorgungsschaltung, um eine Referenzspannung ($V_{REF}$) zu liefern, wenn sie von ersten und zweiten Energieversorgungseinrichtungen ($V_{CC}$, $V_{SS}$) Energie empfängt, und einem Differenzverstärker ($DA_2$), der einen ersten Eingang hat, um ein Datensignal (SD) zu empfangen, und einen zweiten Eingang hat, der angeschlossen ist, um die genannte Referenzspannung ($V_{REF}$) zu empfangen, um eine Potentialdifferenz zwischen dem genannten Datensignal (SD) und der genannten Referenzspannung ($V_{REF}$) zu verstärken, wenn der Verstärker von den genannten ersten und zweiten Energieversorgungseinrichtungen ($V_{CC}$, $V_{SS}$) Energie empfängt, dadurch gekennzeichnet, daß die Referenzpotential-Versorgungsschaltung eine Temperaturkompensations-schaltung ($CP_1$) umfaßt, die mit den genannten ersten und zweiten Energieversorgungseinrichtungen ($V_{CC}$, $V_{SS}$) verbunden und betreibbar ist, um die genannte Referenzspannung ($V_{REF}$) zu erzeugen, mit einer Temperaturcharakteristik, welche eine Variation eines Ausgangssignals ($D_{OUT}$) der Vorrichtung kompensiert, welche sonst bei Änderungen der Umgebungstemperatur auftreten würde, welche Temperaturkompensationsschaltung ($CP_1$) umfaßt:

einen ersten Widerstand ($R_1$), der mit der genannten ersten Energieversorgungseinrichtung ($V_{CC}$) verbunden ist;

einen Anreicherungstyp-Transistor ($Q_{27}$), der ein Drain hat, das mit dem genannten ersten Widerstand ($R_1$) verbunden ist, welches genannte Drain die genannte Referenzspannung ($V_{REF}$) liefert, ein Gate und eine Source, die mit der genannten zweiten Energieversorgungseinrichtung ($V_{SS}$) verbunden sind; und

zweite und dritte Widerstände ($R_2$, $R_3$), die zwischen den genannten ersten und zweiten Energieversorgungseinrichtungen ($V_{CC}$, $V_{SS}$) verbunden sind, um an ihrem Zwischenverbindungspunkt ($N_3$) eine konstante Spannung auf das Gate des Anreicherungstyp-Transistors ($Q_{27}$) aufzubringen.

2. Halbleitervorrichtung mit einer Referenzpotential-Versorgungsschaltung, um eine Referenzspannung ($V_{REF}$) zu liefern, wenn sie von ersten und zweiten Energieversorgungseinrichtungen ($V_{CC}$, $V_{SS}$) Energie empfängt, und einem Differenzverstärker ($DA_2$), der einen ersten Eingang hat, um ein Datensignal (SD) zu empfangen, und einen zweiten Eingang hat, der angeschlossen ist, um die genannte Referenzspannung ($V_{REF}$) zu empfangen, um eine Potentialdifferenz zwischen dem genannten Datensignal (SD) und der genannten Referenzspannung ($V_{REF}$) zu verstärken, wenn der Verstärker von den genannten ersten und zweiten Energieversorgungseinrichtungen ($V_{CC}$, $V_{SS}$) Energie empfängt, dadurch gekennzeichnet, daß die Referenzpotential-Versorgungsschaltung eine Temperaturkompensationsschaltung ($CP_2$) umfaßt, die mit den genannten ersten und zweiten Energieversorgungseinrichtungen ($V_{CC}$, $V_{SS}$) verbunden und betreibbar ist, um die genannte Referenzspannung ($V_{REF}$) zu erzeugen, mit einer Temperaturcharakteristik, welche eine Variation eines Ausgangssignals ($D_{OUT}$) der Vorrichtung kompensiert, welche sonst bei Änderungen der Umgebungstemperatur auftreten würde, welche Temperaturkompensationsschaltung ($CP_2$) umfaßt:

einen Widerstand ($R'_1$), der mit der genannten ersten Energieversorgungseinrichtung ($V_{CC}$) verbunden ist; und

einen Verarmungstyp-Transistor ($Q'_{27}$), der ein Drain hat, das mit dem genannten Widerstand ($R'_1$) verbunden ist, welches Drain die genannte Referenzspannung ($V_{REF}$) liefert, und ein Gate, das mit dessen Source verbunden ist, welche Source mit der genannten zweiten Energieversorgungseinrichtung ($V_{SS}$) verbunden ist.

3. Halbleitervorrichtung nach Anspruch 1 oder 2, bei der der genannte Differenzverstärker ($DA_2$) umfaßt:

erste und zweite Lasteinrichtungen ($Q_{21}$, $Q_{22}$), die mit der genannten ersten Energieversorgungseinrichtung ($V_{CC}$) verbunden sind;

einen ersten Anreicherungstyp-MIS-Transistor ($Q_{23}$), der ein Drain hat, das mit der genannten ersten Lasteinrichtung ($Q_{21}$) verbunden ist, ein Gate, um das genannte Datensignal (SD) zu empfangen, und eine Source;

einen zweiten Anreicherungstyp-MIS-Transistor ($Q_{24}$), der ein Drain, das mit der genannten zweiten Lasteinrichtung ($Q_{22}$) verbunden ist, ein Gate zum Empfangen der genannten Referenzspannung ($V_{REF}$) und eine Source hat; und

eine dritte Lasteinrichtung ($Q_{25}$, $Q_{26}$), die zwischen der genannten zweiten Energieversorgungseinrichtung ($V_{SS}$) und den Sourcen der ersten und zweiten Transistoren ($Q_{23}$, $Q_{24}$) verbunden ist.

4. Halbleitervorrichtung nach Anspruch 3, bei der jede der genannten ersten und zweiten Lasteinrichtungen ($Q_{21}$, $Q_{22}$) Verarmungstyp-Transistoren umfaßt, die ein Drain, das mit der genannten ersten Energieversorgungseinrichtung ($V_{CC}$) verbunden ist, und ein Gate, das mit ihrer Source verbunden ist, haben.

5. Halbleitervorrichtung nach Anspruch 3 oder 4, bei der die genannte dritte Lasteinrichtung ($Q_{25}$, $Q_{26}$) dritte und vierte Anreicherungstyp-Transistoren umfaßt, die parallel angeschlossen sind, jeweils ein Drain, das mit der Source des genannten ersten Anreicherungstyp-Transistors ($Q_{23}$) und mit der Source des genannten zweiten Anreicherungstyp-Transistors ($Q_{24}$) verbunden ist, ein Gate, das mit einer der genannten ersten und zweiten Lasteinrichtungen ($Q_{21}$, $Q_{22}$) verbunden ist, und eine Source, die mit der genannten zweiten Energieversorgungseinrichtung ($V_{SS}$) verbunden ist, haben.

6. Halbleitervorrichtung nach einem der vorhergehenden Ansprüche, ferner mit einem Ausgangspuffer (OB), der zwei Eingangsanschlüsse hat, die jeweils mit einer entsprechenden der genannten ersten und zweiten Lasteinrichtungen ($Q_{21}$, $Q_{22}$) verbunden sind, um jeweilige Ausgangssignale (D, $\bar{D}$) des Differenzverstärkers ($DA_2$) zu empfangen, und einen Ausgangsanschluß zum Erzeugen eines Ausgangssignals ($D_{out}$) der Vorrichtung hat.

7. Halbleitervorrichtung nach Anspruch 6, bei der der genannte Ausgangspuffer (OB) umfaßt:

einen dritten Anreicherungstyp-Transistor ($Q_{31}$), der ein Drain hat, das mit der genannten ersten Energieversorgungseinrichtung ($V_{CC}$) verbunden ist, ein Gate, das mit der genannten ersten Lasteinrichtung ($Q_{21}$) verbunden ist, und eine Source zum Erzeugen des genannten Ausgangssignals ($D_{out}$) der Vorrichtung; und

einen vierten Anreicherungstyp-Transistor ($Q_{32}$), der ein Drain hat, das mit der Source des genannten dritten Anreicherungstyp-Transistors ($Q_{31}$) verbunden ist, ein Gate, das mit der genannten zweiten Lasteinrichtung ($Q_{22}$) verbunden ist, und eine Source, die mit der genannten zweiten Energieversorgungseinrichtung ($V_{SS}$) verbunden ist.

8. Halbleitervorrichtung nach einem der vorhergehenden Ansprüche, bei der die Temperaturcharakteristik der genannten Referenzspannung ($V_{REF}$) derart ist, daß sie dem Ausgangssignal ($D_{out}$) der Vorrichtung eine nicht-negative Temperaturcharakteristik verleiht.

9. Halbleitervorrichtung nach Anspruch 8, bei der die genannte nicht-negative Temperaturcharakteristik eine positive Temperaturcharackteristik ähnlich derjenigen eines hohen Potentialspegels ($V_{OH}$) einer externen ECL-Schaltung ist.

**Revendications**

1. Dispositif semi-conducteur comportant un circuit d'alimentation en potentiel de référence qui délivre une tension de référence ($V_{REF}$) lorsqu'il est alimenté à partir d'un premier et d'un second dispositifs d'alimentation ($V_{CC}$, $V_{SS}$) et un amplificateur différentiel ($DA_2$) ayant une première entrée pour recevoir un signal de données (SD) et ayant une seconde entrée connectée pour recevoir ladite tension de référence ($V_{REF}$), afin d'amplifier la différence de potentiel entre ledit signal de données (SD) et ladite tension de référence ($V_{REF}$) quand l'amplificateur est alimenté à partir du premier et du second dispositifs d'alimentation ($V_{CC}$, $V_{SS}$), caractérisé en ce que le circuit d'alimentation en potentiel de référence comporte un circuit compensateur de température ($CP_1$) connecté audit premier et audit second dispositifs d'alimentation ($V_{CC}$, $V_{SS}$) et ayant pour fonction de produire ladite tension de référence ($V_{REF}$) avec une caractéristique de température qui compense les variations du signal de sortie ($D_{OUT}$) du dispositif, apparaissant autrement avec les changements de température ambiante, ledit circuit compensateur de température ($CP_1$) comportant:

une première résistance ($R_1$) connectée audit premier dispositif d'alimentation ($V_{CC}$);

un transistor de type enrichi ($Q_{27}$) ayant un drain connecté à ladite première résistance ($R_1$), ledit drain délivrant ladite tension de référence ($V_{REF}$), une grille et une source connectées audit second dispositif d'alimentation ($V_{SS}$); et

une second et une troisième résistances ($R_2$, $R_3$) connectées entre ledit premier et ledit second dispositifs d'alimentation ($V_{CC}$, $V_{SS}$) pour appliquer une tension constante en leur point d'interconnexion (N3) à la grille dudit transistor de type enrichi ($Q_{27}$).

2. Dispositif semi-conducteur comprenant un circuit d'alimentation en potentiel de référence destiné à délivrer une tension de référence ($V_{REF}$) lorsqu'il est alimenté à partir d'un premier et d'un second dispositif d'alimentation ($V_{CC}$, $V_{SS}$) et un amplificateur différentiel ($DA_2$) ayant une première entrée pour recevoir un signal de données (SD) et ayant une seconde entrée connectée pour recevoir ladite tension de référence ($V_{REF}$) afin d'amplifier la différence de potentiel entre ledit signal de données (SD) et ladite tension de référence ($V_{REF}$) quand l'amplificateur est alimenté à partir du premier et du second dispositifs d'alimentation ($V_{CC}$, $V_{SS}$), caractérisé en ce que le circuit d'alimentation en potentiel de référence comporte un circuit compensateur de tempéra-

ture (CP$_2$) connecté audit premier et audit second dispositifs d'alimentation (V$_{CC}$, V$_{SS}$) et ayant pour fonction de produire ladite tension de référence (V$_{REF}$) avec une caractéristique de température que compense les variations du signal de sortie (D$_{OUT}$) du dispositif, apparaissant autrement avec les changements de température ambiante, ledit circuit compensateur de température (CP$_2$) comportant:

une résistance (R'$_1$) connectée audit premier dispositif d'alimentation (V$_{CC}$); et

un transistor de type appauvri (Q'$_{27}$ ayant un drain connecté à ladite résistance (R'$_1$) ledit drain délivrant ladite tension de référence (V$_{REF}$) et une grille connectée à sa source, la source étant connectée audit second dispositif d'alimentation (V$_{SS}$).

3. Dispositif semi-conducteur selon la revendication 1 ou 2, dans lequel ledit amplificateur différentiel (DA$_2$) comporte:

un premier et un second dispositifs de charge (Q$_{21}$, Q$_{22}$) connectés audit premier dispositif d'alimentation (V$_{CC}$);

un premier transistor MIS de type enrichi (Q$_{23}$) ayant un drain connecté audit premier dispositif de charge (Q$_{21}$), une grille pour recevoir ledit signal de données (SD) et une source;

un second transistor MIS de type enrichi (Q$_{24}$) ayant un drain connecté audit second dispositif de charge (Q$_{22}$), une grille pour recevoir ladite tension de référence (V$_{REF}$) et une source; et

un troisième dispositif de charge (Q$_{25}$, Q$_{26}$) connecté entre ledit second dispositif d'alimentation (V$_{SS}$) et les sources du premier et du second transistors (Q$_{23}$, Q$_{24}$).

4. Dispositif semi-conducteur selon la revendication 3, dans lequel chacun dudit premier et dudit second dispositifs de charge (Q$_{21}$, Q$_{22}$) comporte des transistors du type appauvri ayant un drain connecté audit premier dispositif d'alimentation (V$_{CC}$) et une grille connectée à sa source.

5. Dispositif semi-conducteur selon la revendication 3 ou 4, dans lequel ledit troisième dispositif de charge (Q$_{25}$, Q$_{26}$) comporte un troisième et une quatrième transistors du type enrichi connectés en parallèle, ayant chacun un drain connecté à la source dudit premier transistor de type enrichi (Q$_{23}$) et à la source dudit second transistor de type enrichi (Q$_{24}$), une grille connectée à l'un dudit premier et dudit second dispositifs de charge (Q$_{21}$, Q$_{22}$) et une source connectée audit second dispositif d'alimentation (V$_{SS}$).

6. Dispositif semi-conducteur selon l'une quelconque des revendications précédentes, comportant en outre un tampon de sortie (OB) ayant deux bornes d'entrée connectées chacune à l'un respectif dudit premier et dudit second dispositifs de charge (Q$_{21}$, Q$_{22}$) pour recevoir des signaux de sortie respectifs (D, D̄) de l'amplificateur différentiel (DA$_2$) et ayant une borne de sortie pour produire un signal de sortie (D$_{OUT}$) du dispositif.

7. Dispositif semi-conducteur selon la revendication 6, dans lequel ledit tampon de sortie (OB) comporte:

un troisième transistor de type enrichi (Q$_{31}$) ayant un drain connecté audit premier dispositif d'alimentation (V$_{CC}$), une grille connectée audit premier dispositif de charge (Q$_{21}$) et une source pour produire ledit signal de sortie (D$_{OUT}$) du dispositif; et

un quatrième transistor de type enrichi (Q$_{32}$) ayant un drain connecté à la source dudit troisième transistor de type enrichi (Q$_{31}$), une grille connecté audit second dispositif de charge (Q$_{22}$) et une source connectée audit second dispositif d'alimentation (V$_{SS}$).

8. Dispositif semi-conducteur selon l'une quelconque des revendications précédentes, dans lequel la caractéristique en température de ladite tension de référence (V$_{REF}$) est telle qu'elle confère audit signal de sortie (D$_{OUT}$) du dispositif une caractéristique de température non négative.

9. Dispositif semi-conducteur selon la revendication 8, dans lequel ladite caractéristique de température non négative est une caractéristique de température positive similaire à celle d'un niveau de potentiel haut (V$_{OH}$) d'un circuit extérieur ECL.

# Fig. 1

# Fig. 2

# Fig. 3

# Fig. 4

V_REF

A

B

TEMPERATURE (°C)

# Fig. 5

V_OH

C

D

TEMPERATURE (°C)